# EUROPEAN PATENT APPLICATION

(11) **EP 2 950 352 A2**
(43) Date of publication of application: **02.12.2015**
(21) Application number: 15169736.4
(22) Date of filing: 13.09.2012
(51) Int. Cl.: H01L 31/05

(54) **PHOTOVOLTAIC CELL INTERCONNECT**

(30) Priority: 29.09.2011 US 201161540729 P
(62) Divisional of application: 12775876.1
(71) Applicant: Dow Global Technologies LLC, Midland, MI 48674 (US)
(72) Inventor: CLARK, Lindsey A., Midland, MI Michigan 48642 (US); DEGROOT, Marty W., Middletown, DE Delaware 19709 (US); FEIST, Rebekah K., Midland, MI Michigan 48642 (US); LARSEN, Travis H., Houston, TX Texas 77021 (US); MILLS, Michael E., Midland, MI Michigan 48674 (US); NAMJOSHI, Abhijit A., Midland, MI Michigan 48640 (US); WILSON, Mark B., Clute, TX Texas 77531 (US)
(74) Representative: Beck Greener

(57) **Abstract**

The invention is a photovoltaic article comprising a first photovoltaic cell having a photoelectrically active region which is located between a topside electrode and a backside electrode, at least one first interconnect element in contact with the frontside electrode at a front surface of the cell and the interconnect element is adhered to the topside electrode of the cell, and at least one second interconnect element adhered to the backside electrode. An electronically conductive adhesive having a low Tg is used to adhere the interconnect element to the frontside electrode. The ECA used to adhere the second interconnect element to the backside electrode comprises a metal chelation compound characterized by the presence of a heterocyclic component comprising one of O, N, or S in a ring configuration and at least one additional heteroatom selected from O, N, or S.

## Description

### Field of the Invention

This invention relates generally to interconnected photovoltaic cells and modules and particularly to an improved approach to maintaining good interconnect performance throughout useful life of the cells or module.

### Introduction

Photovoltaic cells typically comprise a photoactive portion that converts light energy to electricity. On the backside of these cells is found a backside electrode and on the front side another electrical collection system. It is common for these cells to be connected in series by multiple thin wires or ribbons that contact the front side of a first cell and the back side on an adjacent cell. This interconnect configuration is commonly referred to as 'string & tab'. Typically an electrically conductive adhesive (ECA) or solder is used to attach the interconnect ribbon to the front and back sides of the adjacent cells.

These interconnect configurations are commonly used with flexible photovoltaic cells such as copper chalcogenide type cells (e.g. copper indium gallium selenides, copper indium selenides, copper indium gallium sulfides, copper indium sulfides, copper indium gallium selenides sulfides, etc.), amorphous silicon cells, crystalline silicon cells, thin-film III-V cells, organic photovoltaics, nanoparticle photovoltaics, dye sensitized solar cells, and combinations of the like.

WO 2009/097161 teaches strings of cells that are electrically joined by conductive tabs or ribbons adhered with an electrically conductive adhesive on the front and back of adjacent cells. This reference indicates that selecting the coefficient of thermal expansion of the ribbon or tab to match the substrate material and the semiflexible nature of the ECA minimizes mechanical stresses decreasing possibility of adhesion failure.

Other examples of approaches to interconnection include US 2009/0266398, US 2009/0260675, U.S. 7,732,229, US 2005/0263179, US 2008/0216887, US 2009/00025788, US 2008/0011350, US 7,432,438, US 6,936,761; US 2007/0251570 and US.S. 7,022,910.

The industry continues to examine alternative approaches to improve interconnection.

### Summary of Invention

Notwithstanding the teachings of WO 2009/097161, the present inventors have discovered that with environmental stress (e.g., ambient heating) device performance degraded over time. Specifically, the applicants discovered electrical contacts in the interconnected cell string are susceptible to increased electrical resistance after environmental exposure. Upon further examination, applicants found a partial loss of electrical contact between the back conductive electrode and the electrical connector (e.g. conductive ribbon).

The inventors have discovered that the electrically conductive adhesive adhering the electrical connector to the backside electrode of a cell should have a high glass transition temperature and/or comprise a metal chelation compound characterized by the presence of a heterocyclic component comprising one of O,N, or S in a ring configuration and at least one additional heteroatom (O, N,S) to avoid a major change in coefficient of thermal expansion of the material in the operating range of temperatures and also to maintain a highly crosslinked system to prevent the migration of conductive particles in the ECA in the operating range of temperatures. At the same time, it was surprisingly discovered that lower glass transition adhesives function better as the adhesive between the top or front surface of the photovoltaic cell and the electrical connection system or electrical connector. The presence of the metal chelation compound is particularly important in IB-IIIA type photovoltaic cells where a residual presence of a chalcogen is found on the backside electrode.

Thus, according to one aspect, the invention is a photovoltaic article a photovoltaic article comprising a first photovoltaic cell having a photoelectrically active region which is located between a frontside electrode and a backside electrode, at least one first interconnect element in contact with the frontside electrode at a front surface of the cell and the interconnect element is adhered to the frontside electrode of the cell, and at least one second interconnect element adhered to the backside electrode, wherein the first interconnect elements is adhered to the frontside electrode using electrically conductive adhesives having a Tg no greater than 70°C and the second interconnect element is adhered to the backside electrode using a backside electrically conductive adhesive characterized by at least one of the following features: a glass transition temperature of at least 85 C and the backside electrically conductive adhesive comprises a metal chelation compound characterized by the presence of a heterocyclic component comprising one of O, N, or S in a ring configuration and at least one additional heteroatom selected from O, N, or S..

Preferably, the photovoltaic article is a string of at least two such photovoltaic cells where the electrical connector in contact with the backside electrode of the first photovoltaic cell as described above extends beyond the edge of that cell and is in contact with a frontside electrode of an adjacent cell. More, preferably the article has three or more such cells each having an electrical connector in contact with the backside electrode of one cell and also in contact with the frontside electrode of an adjacent cell. Preferably, in each case an electrically conductive adhesive having a glass transition temperature no greater than 70°C adheres the interconnect elements to the front surface of the photovoltaic cells and an electrically conductive adhesive having a glass transition temperature of at least 85 °C adheres the interconnect elements to the backside electrode of the photovoltaic cells.

### Brief Description Of the Drawings

Fig. 1 is a schematic showing the frontside view of a representative electrical connection from one photovoltaic cell to an adjacent photovoltaic cell.
Fig. 2 is a schematic of a cross-section showing a representative electrical connector from one cell to an adjacent cell.
Fig. 3 is a graph showing the performance of photovoltaic articles having two different electrically conductive adhesives compared to articles having only a single type of electrically conductive adhesive.

### Detailed Description

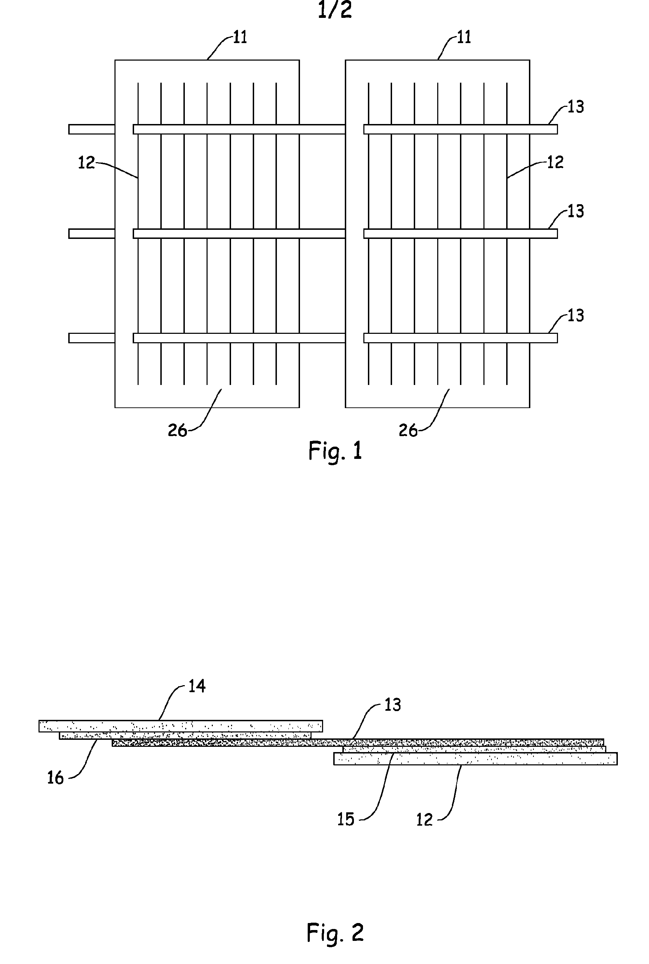

Fig. 1 shows a frontside view of an exemplary embodiment of the photovoltaic article of this invention in this case showing two adjacent photovoltaic cells 11. Fig. 2 shows a cross section at the location of one interconnect element. Each cell has a backside electrode 14 and a frontside electrical collection system 12, in this case shown as a series of thin wires, located on a frontside transparent electrical contact 26 (region between the wires 12). According to one approach the frontside electrical collector can extend beyond the edge of the first cell to contact the backside of the second cell. In this approach the electrical collection system also serves as the cell to cell electrical connector. This approach is not shown in Figs.1 and 2. Alternatively, as shown in Figs. 1 and 2 a separate electrical connector, in this case a conductive ribbon 13 is provided to connect the frontside electrical collector 12 of the first cell to the backside electrode 14 of the second cell. Additional cells may be added to form a string of the length desired the terminal cells will have electrical leads (not shown) provided to enable connection of the cell into a more complex array (formed by modules made of the subject string) or to a electric service system.

The photovoltaic cells 11 used in this invention may be any photovoltaic cells used in the industry. Examples of such cells include crystalline silicon, amorphous silicon, CdTe, GaAs, dye-sensitized solar cells (so-called Gratezel cells), organic/polymer solar cells, or any other material that converts sunlight into electricity via the photoelectric effect. However, the photoactive layer is preferably a layer of IB-IIIA-chalcogenide, such as IB-IIIA-selenides, IB-IIIA-sulfides, or IB-IIIA-selenide sulfides. More specific examples include copper indium selenides, copper indium gallium selenides, copper gallium selenides, copper indium sulfides, copper indium gallium sulfides, copper gallium selenides, copper indium sulfide selenides, copper gallium sulfide selenides, and copper indium gallium sulfide selenides (all of which are referred to herein as CIGSS). These can also be represented by the formula CuIn(1-x)GaxSe(2-y)Sy where x is 0 to 1 and y is 0 to 2. The copper indium selenides and copper indium gallium selenides are preferred. CIGSS cells usually include additional electroactive layers such as one or more of emitter (buffer) layers, conductive layers (e.g. transparent conductive layer used on the frontside) and the like as is known in the art to be useful in CIGSS based cells are also contemplated herein.

The cells have a backside electrode. Typically the backside electrode will comprise metal foils or films or will be such a foil, film or a metal paste or coating on a nonconductive or conductive substrate. Suitable materials include, but are not limited to metal foils or films of stainless steel, aluminum, titanium or molybdenum. Stainless steel and titanium are preferred. Preferably, the electrode structure including the substrate is flexible. The substrate can be coated with optional backside electrical contact regions on one or both sides of the substrate. Such regions may be formed from a wide range of electrically conductive materials, including one or more of Cu, Mo, Ag, Al, Cr, Ni, Ti, Ta, Nb, W combinations of these, and the like. Conductive compositions incorporating Mo may be used in an illustrative embodiment. Trace amounts or more of chalcogen containing substances may be found on the backside electrode surface, particularly when the photoactive layer is a IB-IIIA chalcogenide. These chalcogen substances may be residual from the formation process of the photoactive layer. When these substances are found it is particularly helpful to use a backside ECA that includes a metal chelation compound characterized by the presence of a heterocyclic component comprising one of O,N, or S in a ring configuration and at least one additional heteroatom selected from O, N, or S. Examples of such compounds include quinolines, pyrazoles, triazoles, heterocyclic amines, and thiazolines and particularly hydroxy substituted species of these compounds.

The cells will have a frontside electrical collection system comprising a front electrode, which serves to collect photogenerated electrons from the photoactive region. The transparent frontside electrical contact 26 (also referred to as TCL) is formed over the photoactive region on the light incident surface of the photovoltaic device. The TCL has a thickness in the range from about 10 nm to about 1500 nm, preferably about 100 nm to about 200 nm. The TCL may be a very thin metal film that has transparency to the relevant range of electromagnetic radiation or more commonly is a transparent conductive oxide (TCO). A wide variety of transparent conducting oxides (TCO) or combinations of these may be used. Examples include fluorine-doped tin oxide, tin oxide, indium oxide, indium tin oxide (ITO), aluminum doped zinc oxide (AZO), gallium doped zinc oxide, zinc oxide, combinations of these, and the like. In one illustrative embodiment, the TCO region XX is indium tin oxide. TCO layers are conveniently formed via sputtering or other suitable deposition technique.

In some cases, the transparent conductive layer, may not be conductive enough to enable sufficient collection of electrons from the device. Thus, the front electrode region may also comprise an electrical collection system 12 (often a grid or mesh of thin wire lines) region. The grid region desirably at least includes conductive metals such as nickel, copper, silver, aluminum, tin, and the like and/or combinations thereof. In one illustrative embodiment, the grid comprises silver. Since these materials are not transparent, in one illustrative embodiment they are deposited as a grid or mesh of spaced apart lines so that the grid occupies a relatively small footprint on the surface (e.g., in some embodiments, the grid occupies about 10% or less, even about 5% or less, or even about 2% or less of the total surface area associated with light capture to allow the photoactive materials to be exposed to incident light). The grid region can be formed by one of several known methods including but not limited to screen printing, ink jet printing, electroplating, sputtering, evaporating and the like.

The grid electrical collection system may itself extend beyond the top edge of a cell to be contacted with the backside of an adjacent cell thus forming the electrical connector. More preferably as shown in Figs. 1 and 2 additional interconnect element(s) 13 that can be in the form of one or more thin wires or ribbons or wire mesh are provided. The interconnect elements are comprised of one or more conductive metals such as Cu, Ag, Sn, Al, Au, Fe:Ni, W, Ti, and the like. In preferred embodiments, the interconnect elements comprise a Cu or Fe:Ni ribbon that is coated with a thin layer of Sn or Sn:Ag. The interconnect elements connect adjacent cells and can also be used to connect the cells to external circuitry such as terminal bars. In an exemplary embodiment, the interconnect elements are connected to terminal bars at the leading and trailing edges of the interconnected cell assembly.

It is desirable to limit the amount of shading to the photoactive portion caused by interconnect elements and collection system, while providing enough conductive material to provide electrical continuity that maximizes efficiency of the cell. The interconnect elements 13 are adhered to the frontside of the photovoltaic cell (often a transparent conductive layer or collection grid) by use of an electrically conductive adhesive. As noted previously, an extension of the frontside electrical collector or a conductive ribbon will serve as the electrical connector, extending beyond the edge of the first cell to enable it to contact the backside of the adjacent cell. This electrical connector is also connected to the backside electrode by an electrically conductive adhesive such as a silver filled epoxy resin.

The electrically conductive adhesives (ECA) may be any such as are known in the industry. Such ECA's are frequently compositions comprising a thermosetting polymer matrix with electrically conductive polymers. Such thermosetting polymers include but are not limited to thermoset materials having comprising epoxy, cyanate ester, maleimide, phenolic, anhydride, vinyl, allyl or amino functionalities or combinations thereof. The conductive filler particles may be for example silver, gold, copper, nickel, carbon nanotubes, graphite, tin, tin alloys, bismuth or combinations thereof, Epoxy based ECAs with silver particles are preferred.

Surprisingly, the inventors have discovered the performance of the cells or modules under environmental stresses such as damp heat, dry heat or thermal cycling is enhanced if the electrically conductive adhesive (ECA) 15 employed to connect interconnect elements 13 to the electrically conductive front side electrode 12 has substantially different physical properties compared to the electrically conductive adhesive 16 used to adhere the interconnect elements 13 to the electrically conductive back side electrode. In particular, the backside ECA 16 should have a high glass transition temperature (Tg). Thus, the back side ECA 16 should have a Tg that is greater than the highest operating temperature of the PV module. For terrestrial PV systems, this upper operating temperature may be as high as 85-90°C. Therefore, the backside ECA 16 has a Tg greater than about 85°C, more preferably greater than about 95°C, even more preferably greater than 105°C. It has been demonstrated that the electrical performance of the backside ECA is better under thermal or environmental stress if the ECA has a Tg greater than about 100°C. The Tg as used herein is as measured by differential scanning calorimetry.

The formulation can optionally include additives to improve the long term performance of the cell. Additives including flexibilizers, toughening agents, antioxidants, chelants, corrosion inhibitors, sintering agents, or surface modifiers are suitable. Examples of suitable materials include CE3103WLV from Henkel^{®} and 124-08 from Creative Materials Inc®. Experiments demonstrated that the resistance measured between interconnect elements (ribbons), when heating a cell prepared with a low Tg ECA for backside electrode ribbon attachment, dramatically increases upon exceeding the Tg of the ECA. The results are shared in example 3.

One might expect that the ECA useful for attaching the connector to the backside would also be suitable for adhering such connectors to the frontside. Surprisingly, the inventors have found that lower glass transition adhesives function better as the frontside ECA between the front surface of the photovoltaic cell and the electrical connection system. It is described in example 2 that the use of a high Tg ECA at the frontside electrode can result in damage to the cell. In particular, it has been observed that the use of a high Tg ECA at the front electrode can result in delamination at backside or internal interfaces (e.g. CIGS/molybdenum backside electrode interface) along a portion of the ECA/interconnect element bond line. Again, without wishing to be bound, it is contemplated that the use of a high Tg ECA at the front side results in too high of cure stress that causes delamination at the CIGS/Mo interface. The inventors have found that the frontside ECA 15 should have a glass transition temperature of less than 70°C, preferably less than 50°C, more preferably less than about 30°C and even more preferably less than about 10°C. It is contemplated that the front side ECA may be most effective if the Tg of the front side ECA 15 is lower than the lowest use temperature of a PV module, or about -40°C. Examples of suitable materials include DB1541-S and DB1508 formulations offered by Engineered Conductive Materials^{®} (ECM) or CA 3556 HF from Henkel^{®}.

In another aspect of the invention, the photovoltaic article or interconnected cell assembly may be connected to terminal bars at one or both ends of the string, or at other regions as necessary to connect the module to external circuitry. In an exemplary embodiment, an interconnect element is connected from the backside electrode of the first photovoltaic cell to a terminal bar at the leading edge of the interconnected assembly, and an interconnect element is also connected from the frontside electrode of the last photovoltaic cell to a terminal bar at the trailing edge of the interconnected assembly. It is contemplated that the connection may be created and/or maintained between the interconnect element and the terminal bar via a wide variety of joining techniques including but not limited to welding, soldering, or electrically conductive adhesive.

It is contemplated that the photovoltaic article may further comprise optional encapsulant layers that may perform several functions. For example, the encapsulant layers may serve as a bonding mechanism, helping hold the adjacent layers of the module together. It should also allow the transmission of a desirous amount and type of light energy to reach the photovoltaic cell (e.g. the photoactive portion). The encapsulant layers may also function to compensate for irregularities in geometry of the adjoining layers or translated through those layers (e.g. thickness changes). It also may serve to allow flexure and movement between layers due to environmental factors (e.g. temperature change, humidity, etc.) and physical movement and bending. In a preferred embodiment, first encapsulant layer may consist essentially of an adhesive film or mesh, but is preferably a thermoplastic material such as EVA (ethylene-vinyl-acetate), thermoplastic polyolefin or similar material. It is contemplated that the encapsulant layers may be comprised of a single layer or may be comprised of multiple layers (e.g. a first, second, third, fourth, fifth layer, etc. The preferred thickness of this layer can range from about 0.1mm to 1.0mm, more preferably from about 0.2mm to 0.8mm, and most preferably from about 0.25mm to 0.5mm.

Additional front and backside barrier layers may also be used. Frontside barriers must be selected from transparent or translucent materials. These materials may be relatively rigid or may be flexible. Glass is highly useful as a frontside environmental barrier to protect the active cell components from moisture, impacts and the like. A backside barrier or backsheet may also be used. It is preferably constructed of a flexible material (e.g. a thin polymeric film, a metal foil, a multi-layer film, or a rubber sheet). In a preferred embodiment, the back sheet material may be moisture impermeable and also range in thickness from about 0.05mm to 10.0 mm, more preferably from about 0.1mm to 4.0mm, and most preferably from about 0.2mm to 0.8mm. Other physical characteristics may include: elongation at break of about 20% or greater (as measured by ASTM D882); tensile strength or about 25MPa or greater (as measured by ASTM D882); and tear strength of about 70kN/m or greater (as measured with the Graves Method). Examples of preferred materials include glass plate, aluminum foil, Tedlar® (a trademark of DuPont) or a combination thereof. A supplemental barrier sheet which is connectively located below the back sheet. The supplemental barrier sheet may act as a barrier, protecting the layers above from environmental conditions and from physical damage that may be caused by any features of the structure on which the PV device 10 is subjected to (e.g. For example, irregularities in a roof deck, protruding objects or the like). It is contemplated that this is an optional layer and may not be required. Alternately the protective layer could be comprised of more rigid materials so as to provide additional roofing function under structural and environmental (e.g. wind) loadings. Additional rigidity may also be desirable so as to improve the coefficient of thermal expansion of the PV device and maintain the desired dimensions during temperature fluctuations. Examples of protective layer materials for structural properties include polymeric materials such polyolefins, polyester amides, polysulfone, acetel, acrylic, polyvinyl chloride, nylon, polycarbonate, phenolic, polyetheretherketone, polyethylene terephthalate, epoxies, including glass and mineral filled composites or any combination thereof.

In addition to the encapsulant and barrier materials, a framing material may also be provided to enable attachment of the photovoltaic article to structures such as buildings and to enable and protect electrical interconnects between articles and from articles to other electrical devices. See for example the frame, preferably prepared by injection molding around a laminate structure, to form a building integrated photovoltaic device as shown in WO 2009/137353.

The advantage of the invention described is reflected in the stability of the photovoltaic strings when exposed to environmental stress such as ambient heat. Further illustrative examples are provided in which the photovoltaic performance of devices was monitored over time during exposure to ambient heat conditions of 85°C and compared with conventional 5-cell strings. CIGS-based modules, prepared with and without conductive element 15, made substantially as described in Examples 1-3, were subjected to ambient heat at85°C environmental weathering conditions. During the exposure, the solar cell laminates are positioned vertically on a stainless steel fixture within an oven held at 85°C ± 2°C. Module electrical performance is mathematically extracted from a current-voltage (I-V) characteristic curve that is measured prior to environmental exposure and at various intervals using a Spire 4600class AAA solar simulator under AM1.5,1000 W/m². During the I-V characteristic measurement, the temperature of the module is maintained at 25°C. The I-V characteristic measurement apparatus and procedure meet the requirements specified in the IEC 60904 (parts 1 - 10) and 60891 standards. Immediately following this measurement the devices are returned to the ambient heat environment for the next test period. This process is repeated for each time period. For each I-V measurement, electrical contact is established at the electrical connectors attached to the terminal bars at the leading and trailing ends of the electrical assembly. The power is measured by varying the resistive load between open and closed circuit. The maximum power (Pmax) is calculated as the area of the largest rectangle under the current-voltage (I-V) characteristic curve. The series resistance (Rs) is the slope of the line near open-circuit voltage (Voc), not taken from a diode fit.

Optionally to further enhance electrical connection a conductive patch is placed over at least a portion of the region where the interconnect element is adhered to the backside electrode. The patch may be electrically conductive tape.

### Example 1

CIGS cells screen printed with thin conductive lines on the frontside but without interconnect elements (ribbons) were obtained. Using a stencil a low Tg ECA, DB1541-S from Engineered Conductive Materials, having a Tg of -30°C was equally applied to the three screen printed bus patterns on the frontside electrode of the cell. The stencil was removed and a ribbon was placed on top of each ECA dispense regions. High temperature polyimide tape was used to hold the ribbons in place until the ECA was cured. The three ribbons attached to the frontside electrode each had a portion of the ribbon extending beyond the trailing edge of the cell. A similar stencil was used to apply a high Tg ECA, Emmerson and Cumings CE3103WLV, having a Tg of 114°C and comprising a hydroxyquinoline corrosion inhibitor, equally in three regions on the backside electrode of the same cell. The stencil was removed and a ribbon was placed on top of each of the ECA dispense regions. The three ribbons attached to the backside electrode each had a portion of the ribbon extending beyond the leading edge of the cell. All interconnect ribbons were 2.5 mm wide and had a thickness of approximately 0.1 mm. The cells were then placed between two pieces of tempered glass and placed in a laboratory oven that was pre-heated to 180°C. The cells were left in the oven for 40 minutes to allow a controlled cure for the ECA's. After 40 minutes, the samples were removed from the oven and the polyimide tape was removed from each of the ribbons. The above process was repeated twice, once using a high Tg ECA, Emmerson and Cumings CE3103WLV, to attach the ribbons to both the frontside electrode and the backside electrode; and a second time using a low Tg ECA, DB1541-S fᵣₒₘ Engineered Conductive Materials, to attach the ribbons to both the frontside electrode and the backside electrode.

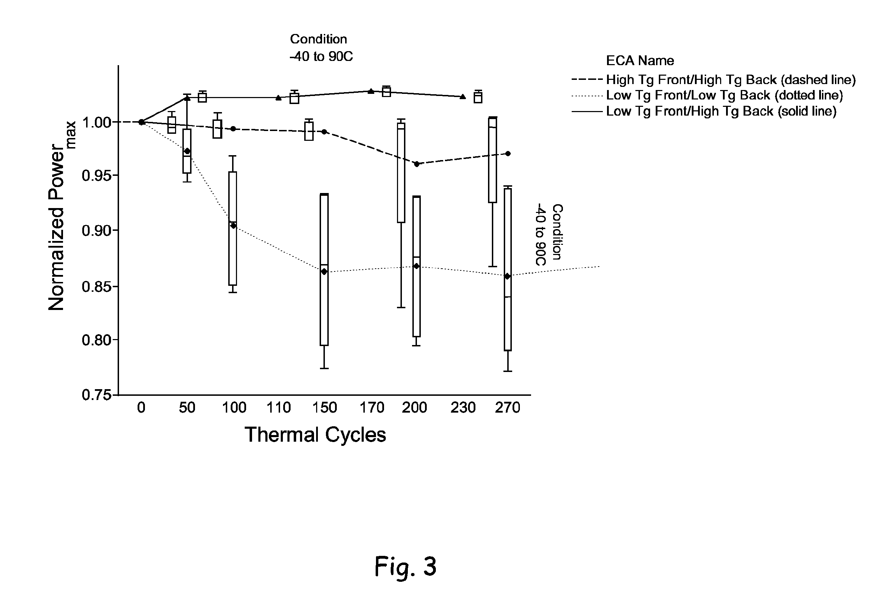

The cells were then laid up into a pre-laminate format in the following order: Glass/polyolefin encapsulant/cell/polyolefin encapsulant/backsheet/polyolefin encapsulant/TPO. The pre-laminate was then laminated in a clamshell type laminator at 150 degrees C. After the laminates were formed, the solar cell laminates were placed into environmental exposure chambers for stability testing. Fig. 3 illustrates the improved performance of the dual ECA solution over a single ECA solution in Thermal Cycling (-40 degrees C to 90 degrees C) in a laminated format and shows that articles with a Low Tg frontside ECA and a high Tg backside ECA retain a higher maximum power.

### Comparative Example 2:

Single cell solar cells were fabricated in the same manner as example 1, except that a high Tg ECA, Emmerson and Cumings CE3103WLV, was used to attach the ribbons to both the frontside electrode and the backside electrode. After the ECA was fully cured in the oven and the polyimide tape was removed from the ribbons, delamination of the ribbon from the frontside electrode was observed in approximately 1 of every 6 ribbons. The ribbon delamination was considered a failure of the part.

### Comparative Example 3:

Single cell solar cells were fabricated in the same manner as example 1. Half of the samples were produced using a low Tg ECA, DB1541-S from Engineered Conductive Materials to attach the ribbons to the backside electrode and the other half of the samples were produced using a high Tg ECA, Emmerson and Cumings CE3103WLV, to attach the ribbons to the backside electrode. In contrast to Example 1, the cells were not laminated. The cells were placed sunny side down in a laboratory oven that was at ambient temperature. A multimeter was connected to two of the interconnect elements (ribbons) connected to the backside electrode, registering the resistance between. A thermocouple was adhered to the backside electrode to report the cell temperature. The oven was then heated up to 120°C and the resistance between the two ribbons (ribbon-to-ribbon resistance) was measured every 10 °C increase in temperature. Articles made using the high Tg ECA at the backside electrode showed little to no increase in ribbon-to-ribbon resistance as the temperature was increased which those made using a low Tg ECA at the backside showed an increase of resistance of more than twice the initial resistance.

## Claims

1. A photovoltaic article comprising a first photovoltaic cell having a photoelectrically active region which is located between a frontside electrode and a backside electrode, at least one first interconnect element in contact with the frontside electrode at a front surface of the cell and the interconnect element is adhered to the frontside electrode of the cell, and at least one second interconnect element adhered to the backside electrode, wherein the first interconnect element is adhered to the frontside electrode using electrically conductive adhesives having a Tg no greater than 70°C and the second interconnect element is adhered to the backside electrode using a backside electrically conductive adhesive comprising a metal chelation compound **characterized by** the presence of a heterocyclic component comprising one of O, N, or S in a ring configuration and at least one additional heteroatom selected from O, N, or S.

2. A photovoltaic article of claim 1 wherein the backside electrically conductive adhesive has a glass transition temperature of at least 85°C.

3. The photovoltaic article of claim 1 or 2 further comprising an additional photovoltaic cell adjacent to the first photovoltaic cell where the additional photovoltaic cell has a photoelectrically active region which is located between a frontside electrode and a backside electrode, wherein the interconnect element in contact with the backside of the first photovoltaic cell is in contact with the frontside electrode of the additional photovoltaic cell.

4. The photovoltaic article of claim 3 wherein there are one or more additional photovoltaic cells each adjacent to another photovoltaic cell, each cell having a photoelectrically active region which is located between a frontside electrode and a backside electrode and connecting each adjacent cell is one or more interconnect element in contact with the frontside electrode of one cell and the backside electrode of the adjacent cell to form a series of interconnected cells

5. The article of claims 3 or 4 wherein for each cell a frontside electrically conductive adhesive adheres the interconnect elements to the front surface of the cell it contacts wherein the frontside electrically conductive adhesive has a glass transition temperature no greater than 70 degrees C and a backside electrically conductive adhesive adheres the interconnect elements to the back electrode of the cell it contacts, the backside electrically conductive adhesive having a glass transition temperature of at least 85 degrees C.

6. The photovoltaic article of any one of claims 1-5 wherein a chalcogen-containing species is found on the backside electrode.

7. A photovoltaic article according to any of the preceding claims further comprising a backside support, a frontside transparent barrier material, and electrical connections to enable transfer of electricity generated in the photovoltaic cell to other electrical devices.

8. The article of claim 7 further comprising an encapsulant material between the backside support and the backside electrode and an encapsulant material between the frontside electrode and the frontside transparent barrier.

9. The article of claim 7 or 8 wherein the frontside transparent barrier is flexible.

10. The article of claim 7 or 8 wherein the frontside transparent barrier is glass.

11. The article of any one of the preceding claims wherein the electrically conductive adhesives are compositions comprising a thermosetting polymer and conductive particles.

12. The article of Claim 11 wherein the thermoset comprises epoxy, cyanate ester, maleimide, phenolic, anhydride, vinyl, allyl or amino functionalities or combinations thereof.

13. The article of claim 11 or 12 wherein the conductive particles are selected from silver, gold, copper, nickel, carbon nanotubes, graphite, tin, tin alloys, bismuth and combinations thereof.
